# EUROPEAN PATENT SPECIFICATION

(11) **EP 2 356 746 B1**
(45) Date of publication and mention of the grant of the patent: **12.11.2014**
(21) Application number: 09749133.6
(22) Date of filing: 12.11.2009
(51) Int. Cl.: H03K 19/018, G06F 13/40

(54) **A LEVEL TRANSLATION CIRCUIT**
PEGELUMSETZUNGSSCHALTUNG
CIRCUIT DE TRANSLATION DE NIVEAU

(30) Priority: 25.11.2008 TR 200808996
(43) Date of publication of application: 17.08.2011
(73) Proprietor: Arçelik Anonim Sirketi, 34950 Istanbul (TR)
(72) Inventor: BASARAN, Fahrettin, 34950 Istanbul (TR)
(86) International application number: PCT/EP2009/065068
(87) International publication number: WO 2010/060804

(56) References cited:
- FR-A1- 2 382 132
- US-A- 4 396 980
- US-A- 5 877 633
- US-A1- 2004 174 188
- US-A1- 2005 100 046

## Description

### Technical Field

The present invention relates to a level translation circuit whereto more than one circuit or circuit element is connected, and which realizes signal level transmission between open drain or open collector buses that operate bidirectionally.

### The Previous Technique

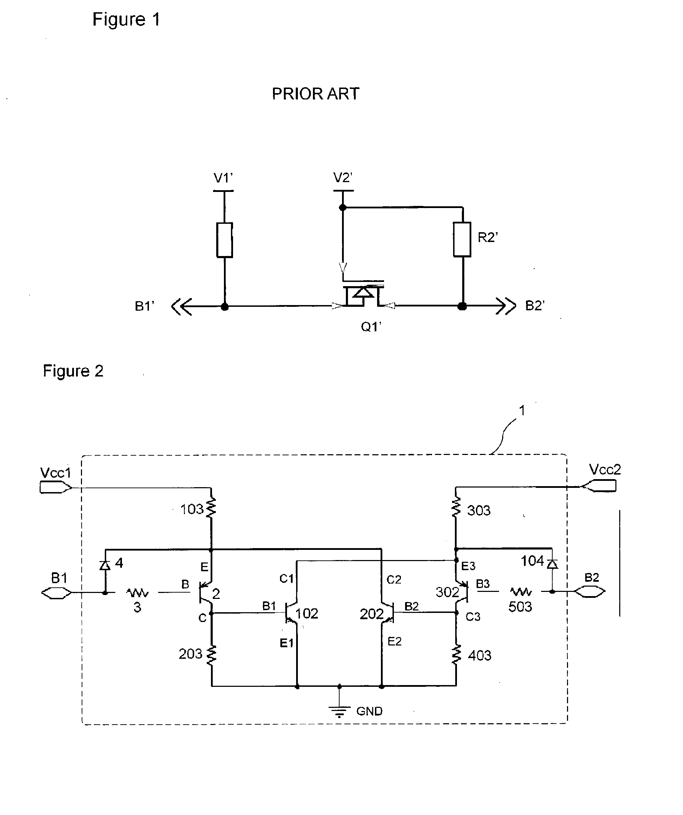

In bidirectional bus connections whereto more than one circuit or component is connected, for example between the integrated circuits and the other electronic parts in an electronic device, open drain or open collector-type connections are used. These connections, used in embodiments wherein more than one device or circuit is connected to a bus, aim to reduce the undesired interactions between the devices connected to each other. The said connections form an interface between the device and/or circuit groups. The output end of the circuit to be connected is connected to a transistor (to the 'base' or 'gate' end) and the signal at the drain or collector end of the transistor is used as the output signal. Therefore, in bidirectional connections, realization of a level translation, that is, transmission of the "low" or "high" logic level in a bus also to the other bus, is required. For level translation, integrated circuits (IC) or MOSFET circuits are used (For example products PCA9517 and P82B715 of the company NXP). In MOSFET circuits, level translation is realized but since the two buses (B1', B2') are connected to each other through the MOSFET (Q1'), the bus loading is not hindered (Figure 1). By means of these circuits, the "low" level is transmitted between the two points (B1', B2') with different "high" levels. However, since the transmission is performed by galvanic connection (through the `drain' and `source' ends of the MOSFET (Q1')), no improvement is performed on the translated signal and one bus cannot be prevented from capacitively affecting the other bus.

In the state of the art Japanese Patent Document No JP10013208, a circuit system, used in buses whereto more than one device input-output is connected with an open drain/collector method, is explained. In this invention designed for using in circuits, all of which operate with the same supply voltage, when the supply is cut off in one circuit, the connection of the circuit with the bus is cut off in order to prevent the loading effect of this circuit on the bus.

A level translation circuit for interconnecting bidirectional busses is disclosed in US 2005/0100046.

### Brief Description of the Present Invention

The aim of the present invention is the realization of a level translation circuit which realizes level transmission between the buses in bidirectional communication structures driven by open drain or open collector outputs.

Another aim of the present invention is the realization of a level translation circuit wherein the communication between the circuits, which are driven by open drain or open collector outputs and which are supplied with different voltages, is provided.

The level translation circuit realized in order to attain the aim of the present invention, explicated in the first claim and the respective claims thereof, provides the signal levels, which drive the circuits with different supply voltages, to be transmitted between the buses at the circuit output. While the circuit or circuits connected to one of the buses are being driven by the signal at the other bus, a small amount of current is drawn from the supply of the circuit being driven and thus, overloading of the supply is prevented. The signal level transmission is provided not by means of galvanic connection but by reproducing a similar signal at the other bus. Thus, the signal transmission is not affected by a bus being capacitively overloaded or by signal waveform distortions.

### Detailed Description of the Present Invention

The level translation circuit realized in order to attain the aim of the present invention is illustrated in the attached figures.
Figure 1 - is the schematic view of a level translation circuit in the previous technique.
Figure 2 - is the schematic view of a level translation circuit.

The elements illustrated in the figures are numbered as follows:
1. Level translation circuit
2. 102, 202, 302 Transistor
3. 103, 203, 303, 403, 503 Resistor
4. 104 Diode

The level translation circuit (1) comprises more than one transistor (2, 102, 202, 302), more than one resistor (3, 103, 203, 303, 403, 503) and more than one diode (4, 104). The level translation circuit (1) is connected between the buses (B1, B2) at the outputs of the open drain or open collector-type circuits, the signal levels at the outputs of which are desired to be equal, and is supplied with supply voltages (Vcc1, Vcc2) that drive the circuits.

The level translation circuit (1) has a symmetrical structure between the two buses (B1, B2) and is formed by bringing similar elements together by similar connections. The level translation circuit (1) transmits the signal in any bus (B1 or B2) to the other bus (B2 or B1) through two transistors (2-102 or 202-302) and a diode that start to transmit, by reproducing the signal. More than one circuit having open drain or open collector connection can be connected to each bus (B1, B2).

The transistors (2, 102, 202, 302) used in the level translation circuit (1) are preferably bipolar junction transistors (BJT) and two of them (2, 302) are PNP-type and the other two of them (102, 202) are NPN-type transistors. A resistor (3) and the anode of a diode (4) are connected to the B1 bus. The other end of the resistor (3) is connected to the base (B) of the transistor (2) and the cathode of the diode (4) is connected to the emitter (E) of the same transistor (2). Furthermore, a resistor (103), which limits the current drawn from Vcc1, is connected between the emitter (E) of the transistor (2) and the Vcc1 supply. Also, a resistor (203) is situated between the collector (C) of the transistor (2) and the ground (GND). The collector (C) of the transistor (2) is connected to the base (B1) of the second transistor (102). The emitter (E1) of the second transistor (102) is connected to the ground (GND).

The other elements of the level translation circuit (1) are symmetrical to the structure explained above and comprise similar elements and connections. Accordingly, a resistor (503) and the anode of a diode (104) are connected to the B2 bus. The other end of the resistor (503) is connected to the base (B3) of the third transistor (302) and the cathode of the diode (104) is connected to the emitter (E3) of the same transistor (302). Furthermore, a resistor (303), which limits the current drawn from Vcc2, is connected between the emitter (E3) of the transistor (302) and the Vcc2 supply. Also, a resistor (403) is situated between the collector (C3) of the transistor (302) and the ground (GND). The collector (C3) of the transistor (302) is connected to the base (B2) of the fourth transistor (202). The emitter (E2) of the fourth transistor (202) is connected to the ground (GND).

The level translation circuit (1) is completed by connecting the emitter (E) of the first transistor (2) to the collector (C2) of the fourth transistor (202) and by connecting the emitter (E3) of the third transistor (302) to the collector (C1) of the second transistor (102) (Figure 2).

The signals at the B1 and B2 buses are the signals, desired to be connected to each other, of the circuits using Vcc1 and Vcc2 supply voltages, respectively. Therefore, the level translation circuit (1) of the present invention provides the signal level ('low' or 'high') in any one of the B1 and B2 buses to be transmitted also to the other bus. The B1 and B2 buses are open drain or open collector-type lines and are connected respectively to the Vcc1 and Vcc2 supply voltages by pull-up resistors (not illustrated in the figures). Unless the signal level at the B1 or B2 bus is drawn to the `low' level by the circuits they are connected to, B1 is at the Vcc1 level and B2 is at the Vcc2 level, that is, when the signal level at any one of the two buses (B1, B2) is 'high', the signal level at the other bus is also 'high'. When the signal level at B1 is 'low', the transistors (2, 102) at the B1-side of the level translation circuit (1) start to transmit, and when the voltage at the collector (C1) of the second transistor (102) decreases, the diode (104) connected to the B2 bus starts to transmit and thus, provides also the signal level at B2 to be 'low'. When the signal level at the B2 bus is 'low', the transistors (302, 402) at the B2-side start to transmit, and the diode (4) connected to the B1 bus provides also the signal level at B1 to be 'low' by starting to transmit. Thus, when the signal level at any one of the buses (B1, B2) is 'low', also the signal at the other bus is drawn to the `low' level. The signals at B1 or B2 can be distorted depending on being received through a long cable or on the related bus being capacitively overloaded. However, the level translation circuit (1) realizes the signal level transmission between the two buses (B1, B2) without forming a direct conductive line therebetween, that is, without a galvanic connection but by reproducing the signal. Since the signal transmission between the buses (by, B2) is not performed by a galvanic connection, the signals at the buses can drive the other bus without being affected by the adverse loading effects and also when the supply voltages (Vcc1, Vcc2) used by the circuits are different.

## Claims

1. A level translation circuit (1) for realizing signal level transmission between a first bus (B1) and a second bus (B2), wherein the first and second buses (B1, B2) are open drain or open collector buses that operate bi-directionally, said level translation circuit (1) comprising more than one transistor (2, 102, 202, 302), more than one resistor (3, 103, 203, 303, 403, 503) and more than one diode (4, 104), wherein the transistors (2, 102, 202, 302) and diodes (4, 104) have a symmetrical structure between the two buses (B1, B2), wherein the level translation circuit (1) is connected between the buses (B1, B2) at the outputs of the open drain or open collector-type circuits, and transmits the signal in any bus (B1 or B2) to the other bus (B2 or B1) through two transistors (2-102 or 202-302) and one of the diodes (4, 104) which provides the signal levels at the outputs of which are desired to be equal, and that are formed by bringing similar elements together by similar connections, wherein two transistors (2-102 or 202-302) and one of the diodes (4, 104) reproduce the signal,
**characterized by** a first, second, third and fourth transistor (2, 102, 302, 202), a first, a second, a third, a fourth, a fifth and a sixth resistor (3, 103, 203, 303, 403, 503) and a first and a second diode (4, 104) arranged in the following manner:
- the first resistor (3) which is connected between the first bus (B1) and the base (B) of the first transistor (2),
- the first diode (4) which is connected between the first bus (B 1) and the emitter (E) of the first transistor (2), the anode of which being connected to the first bus (B1),
- the second resistor (103) which is connected between the emitter (E) of the first transistor (2) and a Vcc1 supply and which limits the current drawn from Vcc1,
- the third resistor (203) which is connected between the collector (C) of the first transistor (2) and ground (GND),
- the sixth resistor (503) which is connected between the second bus (B2) and the base (B3) of the third transistor (302),
- the second diode (104) which is connected between the second bus (B2) and the emitter (E3) of the third transistor (302), the anode of which being connected to the second bus (B2),
- the fourth resistor (303) which is connected between the emitter (E3) of the third transistor (302) and a Vcc2 supply and which limits the current draw from Vcc2,
- the fifth resistor (403) which is connected between the collector (C3) of the third transistor (302) and ground (GND),.
- the first transistor (2) which starts to conduct when the signal level at the first bus (B1) is 'low',
- the second transistor (102), the base (B1) of which is connected to the collector (C) of the first transistor (2), and the collector (C1) of which is connected to the emitter (E) of the third transistor (302) and the emitter (E1) of which is connected to ground (GND);
- the second diode (104) which is connected to the second bus (B2) and which provides the signal level at the second bus (B2) to be 'low' by starting to conduct when the voltage at the collector (C1) of the second transistor (102) decreases depending on the first and second transistors (2, 102) starting to conduct,
- the third transistor (302) which starts to conduct when the signal level at the second bus (B2) is 'low',
- the fourth transistor (202), the base of which is connected to the collector (C3) of the third transistor (302), and the collector (C2) of which is connected to the emitter (E) of the first transistor (2) and the emitter (E2) of which is connected to ground (GND);
- the first diode (4) which is connected to the first bus (B1) and which provides the signal level at the first bus (B1) to be 'low' by starting to conduct when the voltage at the collector (C2) of the fourth transistor (202) decreases depending on the third and fourth transistors (302, 202) starting to conduct.

2. A level translation circuit (1) as in Claim 1, wherein the first and third transistors (2, 302) are PNP-Type BJTs and the second and fourth transistors (102, 202) are NPN-type BJTs.

3. A level translation circuit (1) as in Claim 1 or 2, which is used for connection circuits with Vcc1 and Vcc2 supply voltage values (Vcc1, Vcc2) different from each other.

## Patentansprüche

1. Pegelübersetzungsschaltung (1) zum Erreichen einer Signalpegelübertragung zwischen einem ersten Bus (B1) und einem zweiten Bus (B2), wobei der erste und zweite Bus (B1, B2) Open-Drain- oder Open-Collector-Busse sind, die bidirektional arbeiten, wobei die Pegelübersetzungsschaltung (1) mehrere Transistoren (2, 102, 202, 302), mehrere Widerstände (3, 103, 203, 303, 403, 503) und mehrere Dioden (4, 104) umfasst, wobei die Transistoren (2, 102, 202, 302) und Dioden (4, 104) eine symmetrische Struktur zwischen den zwei Bussen (B1, B2) aufweisen, wobei die Pegelübersetzungsschaltung (1) zwischen den Bussen (B1, B2) an den Ausgängen der Open-Drain- oder Open-Collector-Schaltung verbunden ist und das Signal auf einem beliebigen Bus (B1 oder B2) an den anderen Bus (B2 oder B1) über zwei Transistoren (2-102 oder 202-302) und eine der Dioden (4, 104) überträgt, was für Signalpegel an den Ausgängen derselben sorgt, die gleich sein sollen und die gebildet werden, indem ähnliche Elemente durch ähnliche Verbindungen zusammengebracht werden, wobei zwei Transistoren (2-102 oder 202-302) und eine der Dioden (4, 104) das Signal reproduzieren,
**gekennzeichnet durch** einen ersten, zweiten, dritten und vierten Transistor (2, 102, 302, 202), einen ersten, zweiten, dritten, vierten, fünften und sechsten Widerstand (3, 103, 203, 303, 403, 503) und eine erste und zweite Diode (4, 104), die in folgender Weise angeordnet sind:
- der erste Widerstand (3) ist zwischen dem ersten Bus (B1) und der Basis (B) des ersten Transistors (2) verbunden,
- die erste Diode (4) ist zwischen dem ersten Bus (B1) und dem Emitter (E) des ersten Transistors (2) verbunden, dessen Anode mit dem ersten Bus (B1) verbunden ist,
- der zweite Widerstand (103) ist zwischen dem Emitter (E) des ersten Transistors (2) und einer Vcc1-Versorgung verbunden, was den von Vcc1 aufgenommenen Strom begrenzt,
- der dritte Widerstand (203) ist zwischen dem Kollektor (C) des ersten Transistors (2) und der Masse (GND) verbunden,
- der sechste Widerstand (503) ist zwischen dem zweiten Bus (B2) und der Basis (B3) des dritten Transistors (302) verbunden,
- die zweite Diode (104) ist zwischen dem zweiten Bus (B2) und dem Emitter (E3) des dritten Transistors (302) verbunden, dessen Anode mit dem zweiten Bus (B2) verbunden ist,
- der vierte Widerstand (303) ist zwischen dem Emitter (E3) des dritten Transistors (302) und einer Vcc2-Versorgung verbunden, was den von Vcc2 aufgenommenen Strom begrenzt,
- der fünfte Widerstand (403) ist zwischen dem Kollektor (C3) des dritten Transistors (302) und der Masse (GND) verbunden,
- der erste Transistor (2) beginnt zu leiten, wenn der Signalpegel am ersten Bus (B1) "niedrig" ist,
- bei dem zweiten Transistor (102) ist die Basis (B1) mit dem Kollektor (C) des ersten Transistors (2) verbunden, der Kollektor (C1) ist mit dem Emitter (E) des dritten Transistors (302) verbunden und der Emitter (E1 ist mit der Masse (GND) verbunden;
- die zweite Diode (104) ist mit dem zweiten Bus (B2) verbunden und sorgt dafür, dass der Signalpegel am zweiten Bus (B2) "niedrig" ist, indem sie zu leiten beginnt, wenn die Spannung am Kollektor (C1) des zweiten Transistors (102) abnimmt, abhängig davon, dass der erste und zweite Transistor (2, 102) zu leiten beginnen,
- der dritte Transistor (302) beginnt zu leiten, wenn der Signalpegel am zweiten Bus (B2) "niedrig" ist,
- bei dem vierten Transistor (202) ist die Basis mit dem Kollektor (C3) des dritten Transistors (302) verbunden, und der Kollektor (C2) ist mit dem Emitter (E) des ersten Transistors (2) verbunden, und der Emitter (E2) ist mit der Masse (GND) verbunden;
- die erste Diode (4) ist mit dem ersten Bus (B1) verbunden und sorgt dafür, dass der Signalpegel am zweiten Bus (B1) "niedrig" ist, indem sie zu leiten beginnt, wenn die Spannung am Kollektor (C2) des vierten Transistors (202) abnimmt, abhängig davon, dass der dritte und vierte Transistor (302, 202) zu leiten beginnen.

2. Pegelübersetzungsschaltung (1) nach Anspruch 1, wobei der erste und dritte Transistor (2, 302) BJTs des PNP-Typs sind und der zweite und vierte Transistor (102, 202) BJTs des NPN-Typs sind.

3. Pegelübersetzungsschaltung (1) nach Anspruch 1 oder 2, die für Verbindungsschaltungen mit Vcc1- und Vcc2-Versorgungsspannungswerten (Vcc1 Vcc2) benutzt wird, welche voneinander verschieden sind.

## Revendications

1. Un circuit de translation de niveau (1) pour effectuer la transmission de niveau de signal entre un premier bus (B1) et un deuxième bus (B2), où les premier et deuxième bus (B1, B2) sont des bus à drain ouvert ou à collecteur ouvert qui fonctionnent de manière bidirectionnelle, ledit circuit de translation de niveau (1) comprenant plus d'un transistor (2, 102, 202, 302), plus d'une résistance (3, 103, 203, 303, 403, 503) et plus d'une diode (4, 104), où les transistors (2, 102, 202, 302) et les diodes (4, 104) ont une structure symétrique entre les deux bus (B1, B2), où le circuit de translation de niveau (1) est connecté entre les bus (B1, B2) aux sorties des circuits de type à drain ouvert ou à collecteur ouvert, et transmet le signal dans un bus (B1 ou B2) à l'autre bus (B2 ou B1) au moyen de deux transistors (2-102 ou 202-302) et une des diodes (4, 104) qui fournit des niveaux de signal que l'on souhaite être égal aux sorties de celle-ci, et qui sont formés en rassemblant des éléments semblables par des connexions semblables, où deux transistors (2-102 ou 202-302) et une des diodes (4, 104) reproduisent le signal,
**caractérisé par** un premier, un deuxième, un troisième et un quatrième transistor (2, 102, 302, 202), une première, une deuxième, une troisième, une quatrième, une cinquième et une sixième résistance (3, 103, 203, 303, 403, 503) et une première et une deuxième diode (4, 104) disposés de manière suivante :
- la première résistance (3) qui est connectée entre le premier bus (B1) et la base (B) du premier transistor (2),
- la première diode (4) qui est connectée entre le premier bus (B1) et l'émetteur (E) du premier transistor (2), dont l'anode est connectée au premier bus (B1),
- la deuxième résistance (103) qui est connectée entre l'émetteur (E) du premier transistor (2) et une alimentation Vcc1, et qui limite le courant tiré du Vcc1
- la troisième résistance (203) qui est connectée entre le collecteur (C) du premier transistor (2) et la terre (GND),
- la sixième résistance (503) qui est connectée entre le deuxième bus (B2) et la base (B3) du troisième transistor (302),
- la deuxième diode (104) qui est connectée entre le deuxième bus (B2) et l'émetteur (E3) du troisième transistor (302), dont l'anode est connectée au deuxième bus (B2),
- la quatrième résistance (303) qui est connectée entre l'émetteur (E3) du troisième transistor (302) et une alimentation Vcc2, et qui limite le courant tiré du Vcc2,
- la cinquième résistance (403) qui est connectée entre le collecteur (C3) et du troisième transistor (302) et la terre (GND),
- le premier transistor (2) qui commence à conduire lorsque le niveau de signal au premier bus (B1) est « faible »,
- le deuxième transistor (102), dont la base (B1 est connectée au collecteur (C) du premier transistor (2), et dont le collecteur (C1 est connecté à l'émetteur (E) du troisième transistor (302) et dont l'émetteur (E1 est connecté à la terre (GND),
- la deuxième diode (104) qui est connectée au deuxième bus (B2) et qui assure que le niveau de signal au deuxième bus (B2) est « faible » en commençant à conduire lorsque la tension au collecteur (C1) du deuxième transistor (102) diminue en fonction des premier et deuxième transistors (2, 102) commençant à conduire,
- le troisième transistor (302) qui commence à conduire lorsque le niveau de signal au deuxième bus (B2) est « faible »,
- le quatrième transistor (202), dont la base est connectée au collecteur (C3) du troisième transistor (302), et dont le collecteur (C2) est connecté à l'émetteur (E) du premier transistor (2) et dont l'émetteur (E2) est connecté à la terre (GND),
- la première diode (4) qui est connectée au premier bus (B1) et qui assure que le niveau de signal au premier bus (B1) est « faible » en commençant à conduire lorsque la tension au collecteur (C2) du quatrième transistor (202) diminue en fonction des troisième et quatrième transistors (302, 202) commençant à conduire,

2. Un circuit de translation de niveau (1) selon la Revendication 1, où les premier et troisième transistors (2, 302) sont des transistors bipolaires de type PNP et les deuxième et quatrième transistors (102, 202) sont des transistors bipolaires de type NPN.

3. Un circuit de translation de niveau (1) selon la Revendication 1 ou 2, qui est utilisé pour des circuits de connexion avec des valeurs de tension d'alimentation Vcc1 et Vcc2 (Vcc1, Vcc2) qui sont différentes l'une de l'autre.
